# EUROPÄISCHE PATENTSCHRIFT

(11) **EP 0 529 438 B1**
(45) Veröffentlichungstag und Bekanntmachung des Hinweises auf die Patenterteilung: **03.04.1996**
(21) Anmeldenummer: 92113894.7
(22) Anmeldetag: 14.08.1992
(51) Int. Cl.: B26D 3/28, H05K 3/00

(54) **Vorrichtung zum Trennen und Abziehen einer auf einem Trägermaterial auflaminierten Folie**
Apparatus for separating and peeling a foil from a laminated carrier material
Dispositif pour séparer et enlever une feuille d'un matériau support laminé

(30) Priorität: 22.08.1991 DE 4127724
(43) Veröffentlichungstag der Anmeldung: 03.03.1993
(73) Patentinhaber: HOECHST AKTIENGESELLSCHAFT, D-65926 Frankfurt am Main (DE)
(72) Erfinder: Heist, Hans, W-6200 Wiesbaden (DE); Stork, Martin, W-6052 Mühlheim/Main (DE); Platzer, Stephan J.W., Dr., W-6228 Eltville-Erbach (US)

(56) Entgegenhaltungen:
- EP-A- 0 214 461
- EP-A- 0 286 961
- EP-A- 0 525 692
- US-A- 4 752 346
- IBM TECHNICAL DISCLOSURE BULLETIN Bd. 31, Nr. 7, Dezember 1988, ARMONK, NY. USA Seiten 212-217, XP000027000 "COPPER PEEL MACHINE FOR PRIMTED CIRCUIT BOARDS"

## Beschreibung

Die Erfindung betrifft eine Vorrichtung sowie ein Verfahren zum Trennen und Abziehen einer auf einem Trägermaterial auflaminierten Folie, mit einer horizontalen Grundplatte und einer teilweise darüber im Abstand angeordneten, eine Abzugskante aufweisenden Platte, wobei die Grundplatte und die darüber angeordnete Platte einen ersten Spalt bilden.

Eine derartige Vorrichtung sowie ein entsprechendes Verfahren sind in der nicht vorveröffentlichten EP-A-0 525 692 beschrieben. Darüberhinaus weist diese Trennvorrichtung ein keilförmiges Trennmesser und ein darüber liegendes, mit dem Trennmesser einen parallelen zweiten Spalt bildendes Element auf, und ist über das auf der Grundplatte aufliegende Laminat aus Folie und Trägermaterial hin und her verschiebbar. Des Weiteren ist die Trennvorrichtung gegenüber der Grundplatte in Vertikalrichtung verschiebbar.

Lichtempfindliche Schichten oder Lagen, wie beispielsweise belichtete Fotoresistschichten auf Leiterplatten oder Farbprüffolien, sind im allgemeinen durch Schutzfolien abgedeckt. Bei der Herstellung von Farbprüffolien und gedruckten Leiterplatten wird ein Substrat zuerst mit einem lichtempfindlichen Material beschichtet. Anschließend wird das Material mit einer durchsichtigen Folie abgedeckt. Dieses Laminat aus Folie und lichtempfindlicher Schicht wird dann bildweise durch eine Maske belichtet. Diese Belichtung bewirkt eine bildformende, unterschiedliche Adhäsion der fotoempfindlichen Schicht in der Weise, daß die belichteten Teile mit einer stärkeren Adhäsion auf dem Substrat haften als die unbelichteten Teile. Wenn die Schutzfolie und das Substrat voneinander getrennt werden, befindet sich beispielsweise ein Positivbild auf dem Substrat und ein Negativbild auf der Schutzfolie.

Bei der Herstellung von Leiterplatten für elektrische Schaltungen wird das Substrat mit einem lichtempfindlichen Trockenresitfilm laminiert. Mit Hilfe einer die elektrische Schaltung darstellenden Abbildungsmaske erfolgt die Belichtung des Trockenresistfilms und danach wird die Schutzfolie entfernt und der Trockenresistfilm in verschiedenen Verarbeitungsschritten entwickelt. Die Schutzfolie auf dem Trockenresistfilm ermöglicht eine weitgehende staubfreie Belichtung und den Transport der beschichteten Leiterplatten im gestapelten Zustand. Die Leiterplatten weisen im einzelnen einen oder mehrere Ränder auf, die frei von der auflaminierten Schutzfolie sind, so daß die Platte an diesen freien Rändern von Greifwerkzeugen oder manuell erfaßt werden kann.

Bei einigen Laminiervorgängen ist es erwünscht, eine Beschichtung von einer Oberfläche zu einer anderen Oberfläche vollständig zu übertragen, wie diese beispielsweise bei einer Übertragung einer gefärbten Harzschicht von einem Substrat auf ein Empfangsblatt der Fall ist. In einem solchen Fall werden das beschichtete Substrat und ein darauf gelegtes Empfangsblatt durch einen Laminierspalt von beheizten Laminierwalzen unter Druck hindurchgeführt. Anschließend werden das Substrat und das Empfangsblatt voneinander getrennt und dabei die gefärbte Harzschicht von dem Substrat auf das Empfangsblatt übertragen. Ein Problem bei derartigen Übertragungsverfahren besteht in der Unvollständigkeit der Übertragung der gefärbten Harzschicht.

Das US-Patent 4,752,346 beschreibt eine Vorrichtung und ein Verfahren zum Ablösen und Trennen von aufeinanderklebenden Folien. Die Vorrichtung umfaßt eine Plattform aus einem Metall oder aus einem Material, dessen Oberfläche mit einer elektrischleitenden Schicht ausgestattet ist. Über der Oberfläche befindet sich eine Leistenkante oder ein Keil. Sowohl die Leistenkante als auch die Plattformoberfläche sind elektrisch geerdet. Die Leistenkante ist über der Plattform mittels Stützen an jedem Ende der Leistenkante positioniert. Die Stützen, die von Federn umgeben sind, sind durch die Leistenkante hindurchgeführt und ragen über diese vor. Somit ist es möglich, daß zwischen der Unterseite der Leistenkante und der Oberfläche der Plattform ein variabler Spalt sich ausbilden kann, der es ermöglicht, daß unterschiedlich dicke Laminate aus Substrat und Folie zwischen der Leistenkante und der Oberfläche der Plattform hindurchgeführt werden können. So wird beispielsweise auf eine transparente Polyesterfolie mittels einer Kleberschicht eine gefärbte fotoempfindliche Schicht aufgebracht, die von einem Empfangsblatt abgedeckt ist. Diese Sandwich-Anordnung durchläuft den Spalt von Laminierwalzen und wird anschließend zwischen der Leistenkante und der Plattform der Abzugsvorrichtung eingeführt. Die transparente Polyesterfolie wird über die Leistenkante abgezogen, indem die Folie über den Kantenwinkel geknickt nach oben entlang der Schräge der Leistenkante geführt wird. Dadurch wird die Polyesterfolie von dem Empfangsblatt beziehungsweise der Empfangsfolie getrennt und es erfolgt eine Übertragung der Kleber- und der gefärbten fotoempfindlichen Schicht auf das Empfangsblatt.

Aus der DE-OS 34 43 939 ist ein Verfahren zum Entfernen der Schutzfolie von mit belichtetem Fotoresist laminierten Leiterplatten mit Hilfe eine flächenförmigen Haftelements bekannt, das auf die zu entfernende Schutzfolie geklebt und anschließend im wesentlichen Übereck von der Leiterplatte gezogen wird. Dabei wird die Leiterplatte durch eine Verdrehvorrichtung so justiert, daß sich zwischen der Vorderkante der Platte und der Normalen zur Transportrichtung ein Winkel von 0 ° < α <90 ° einstellt. Anschließend wird das vordere Eck der Platte sowohl ober- als auch unterseitig derart mit einem zweiseitig klebenden Haftelement versehen, daß über den Rand der Schutzfolie hinaus auch Teile der unbedeckten Platte erfaßt werden und die Schutzfolie mittels Walzen abgezogen werden kann. Die Vorrichtung zur Durchführung des Verfahrens umfaßt eine Transport- und Justiereinrichtung, durch welche der plattenförmige Körper aus seiner Transportrichtung in eine Arbeitsposition schwenkbar ist, desweiteren eine Einrichtung zum Auftragen eines zweiseitig klebenden Haftelements, das zangenförmig ausgebildet ist und plattenförmige Körper zur Aufnahmen von Lagerrrollen aufweist und eine Einrichtung zum Entfernen des Haftelements und der mit diesem verbundenen Schutzfolie des plattenförmigen Körpers. Diese Einrichtung weist achsparallel angeordnetes Walzensystem mit einer Einrichtung zur Konstanthaltung des Walzenabstandes auf.

Aus der DE-OS 33 39 723 ist ein Verfahren und eine Vorrichtung zum Ablösen der Schutzfolie von laminierten Leiterplatten bekannt, bei dem die laminierten Leiterplatten über Transportrollen laufend an der Ober- und Unterseite mit einem einseitig beleimten Klebeband versehen werden, wobei durch ein anschießendes Abziehen des aufgebrachten Klebebandes über eine Leistenkante, welche mit der Leiterplatte einen Abziehspalt bildet, die Schutzfolie abgelöst, abtransportiert und gespeichert wird. Die Leistenkante bildet zur Transportvorrichtung einen Winkel von 45° und die sich anschließende Fläche zur Plattenebene ebenfalls einen Winkel von 45°.

Bei den bekannten Vorrichtungen zum Ablösen einer Schutzfolie von einer laminierten Leiterplatte werden entweder ein kontinuierliches beziehungsweise endloses Klebeband oder einzelne, doppelseitig klebende Elemente verwendet, wodurch zusätzliches Material und erhebliche Materialmengen davon benötigt werden. Ferner sind vorab weitere Verfahrensschritte erforderlich, um entweder das Klebeband oder die Klebeelemente auf die Schutzfolie der Leiterplatte aufzubringen.

Aufgabe der Erfindung ist es, hier Abhilfe zu schaffen und eine Vorrichtung und ein Verfahren vorzuschlagen, bei denen ohne Klebeband oder Klebeelement ein sicheres vollständiges und vollautomatisches Ablösen einer Folie von einem Trägermaterial, auf dem eine oder mehrere lichtempfindliche Schichten aufgebracht sind, erfolgt.

Diese Aufgabe wird in einer Vorrichtung nach dem Oberbegriff des Anspruchs 1 in der Weise gelöst, daß eine Trennvorrichtung entlang einer Spindel mit Hilfe eines Motors über das auf der Grundplatte aufliegende Laminat aus Folie und Trägermaterial, bis über die Platte hin und her verfahrbar ist, wobei die Trennvorrichtung gegenüber der Grundplatte in Vertikalrichtung verschiebbar ist, daß die Trennvorrichtung ein keilförmiges Trennmesser und ein darüber liegendes, mit der schräg zu der horizontalen geneigten Oberseite des Trennmessers einen parallelen zweiten Spalt bildendes Element aufweist, wobei mittels einer Druckrolle, die in dem als Trennmesserkopf ausgebildeten Element oberhalb des zweiten Spalts angeordnet und auf der schrägen Oberseite des Trennmessers hin und her beweglich ist, eine in den zweiten Spalt eingefädelte Folienecke festklemmbar ist, und daß das Laminat während des Einfädelns einer losgelösten Folienecke mittels eines hin und her bewegbaren Stempels, der die Grundplatte vertikal durchsetzt, im ersten Spalt festklemmbar ist.

In Ausgestaltung der Erfindung ist die Trennvorrichtung an der Unterseite eines Winkelrahmens befestigt, in dessen vertikalem Schenkel am unteren Ende eine Rolle drehbar gelagert ist.

In Weiterbildung der Erfindung bildet das Trennmesser die Unterseite dieses Spalts, der einen Winkel im Bereich von 5 bis 25°, insbesondere von 10 bis 20°, in Vorschubrichtung der Trennvorrichtung mit der Horizontalen einschließt.

Die weitere Ausgestaltung der Erfindung ergibt sich aus den Patentansprüchen 4 bis 12.

Die Aufgabe wird ebenfalls durch ein Verfahren nach Anspruch 13 gelöst.

Das Verfahren zum Trennen und Abziehen einer auf einem Trägermaterial auflaminierten Folie, wobei das Laminat aus Folie und Trägermaterial auf einer horizontalen Grundplatte aufgelegt und mit seiner Diagonalen in einer parallel zur Grundplatte verlaufenden Vorschubrichtung einer Trennvorrichtung ausgerichtet wird, besteht darin, daß, getrennt durch einen ersten Spalt, eine Platte oberhalb der Grundplatte so angeordnet ist, daß zumindest eine Folienecke des im ersten Spalt frei beweglichen Laminats nicht durch die Platte abgedeckt wird, daß das Laminat im ersten Spalt festgeklemmt wird und die Folienecke infolge einer Vorschubbewegung der Trennvorrichtung mit Hilfe eines keilförmigen Trennmessers der Trennvorrichtung von dem Trägermaterial losgelöst und in einen schräg zur Horizontalen verlaufenden, oberhalb des Trennmessers liegenden zweiten Spalt eingefädelt wird, daß während einer weiteren Vorschubbewegung das festgeklemmte Laminat freigegeben und die Folienecke selbstklemmend im zweiten Spalt festgehalten wird und auf die Folienecke ein zusätzlicher Klemmdruck ausgeübt wird, der die Selbstklemmung der in den zweiten Spalt eingefädelten Folienecke unterstützt, wobei durch die weitere Vorschubbewegung und ein gleichzeitiges vertikales Abheben von der Grundplatte der über eine Schräge auf die Oberseite der Platte auflaufenden Trennvorrichtung die Folie vollständig von dem Trägermaterial abgezogen wird.

Der zusätzliche Klemmdruck auf die Folienecke im zweiten Spalt dient vor allem dazu, großformatige Laminate und/oder dünne Trägermaterialien, die den zweiten Spalt wegen ihrer geringen Dicke nicht voll ausfüllen, ausreichend festzuhalten.

Weitere vorteilhafte Verfahrensschritte ergeben sich aus den Ansprüchen 14 und 15.

Im folgenden wird die Erfindung anhand von zwei zeichnerisch dargestellten Ausführungsbeispielen näher erläutert. Es zeigen:
- Figur 1: eine Seitenansicht der Vorrichtung nach der Erfindung, teilweise aufgebrochen,
- Figur 2: eine Draufsicht auf die Vorrichtung nach Figur 1,
- Figur 3: einen Schnitt durch einen Teil der Vorrichtung in Seitenansicht, in einer Stellung der Trennvorrichtung unmittelbar vor einer Folienecke, der von einem Trägermaterial abzulösenden Folie,
- Figur 4: in geschnittener Seitenansicht die auf eine Schräge einer Platte auflaufende Trennvorrichtung, mit in einem Spalt eingefädelter Folienecke,
- Figur 5: in geschnittener Seitenansicht die auf die Oberseite der Platte aufgelaufene Trennvorrichtung, mit teilweise von dem Trägermaterial abgelöster Folie, und
- Figur 6: in geschnittener Seitenansicht eine weitere Ausführungsform der Trennvorrichtung, die in einem Trennmesserkopf eine Druckrolle enthält.

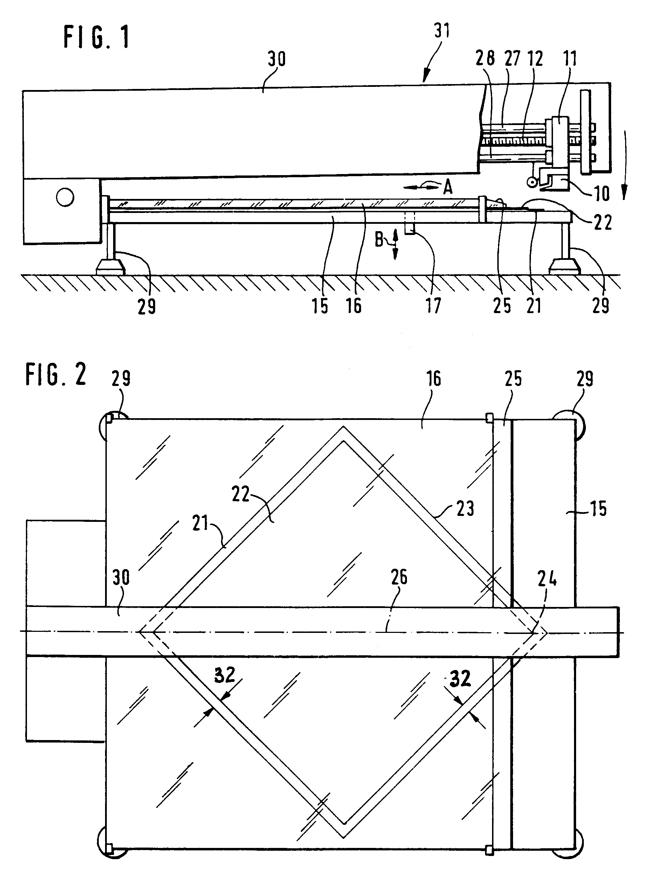

In Figur 1 ist eine Vorrichtung 31 zum Trennen und Abziehen einer Folie 22 von einem Trägermaterial 21 schematisch in Seitenansicht dargestellt. Die Vorrichtung 31 besteht aus einer Grundplatte 15, die sich auf vier Standbeinen 29 an den Ecken der Grundplatte abstützt, einer transparenten Platte 16, einer über einen Motor, der gegenüber einer Führung 11 angeordnet ist, angetriebenen Spindel 12, auf der eine Trennvorrichtung 10 aufsitzt und über die Grundplatte 15 hin und her verfahrbar ist, wie es der Doppelpfeil A zeigt sowie einem Stempel 17, der die Grundplatte 15 durchsetzt und angehoben und abgesenkt werden kann, wie dies der Doppelpfeil B andeutet. Die transparente Platte 16 ist über der Grundplatte 15 in einem bestimmten Abstand angeordnet und besitzt eine Schräge 25. In dem Spalt zwischen der Grundplatte 15 und der Platte 16 werden das Trägermaterial 21 mit der auflaminierten Folie 22 eingeschoben. Die Platte 16 deckt die Grundplatte 15, wie aus den Figuren 1 und 2 ersichtlich ist, nicht vollständig ab, sondern ist in Vorschubrichtung der Trennvorrichtung 10 kürzer als die Grundplatte 15.

Die Platte 16 besteht aus einem transparenten Material, beispielsweise Glas oder Kunststoff, wobei Glas bevorzugt wird. Das Trägermaterial 21 kann eine Folie sein, auf der beispielsweise eine gefärbte, lichtempfindliche Kunstharzschicht aufgebracht ist. Die darüber laminierte Folie 22 dient dann als Empfangsfolie für diese gefärbte Kunstharzschicht, die im allgemeinen eine Polymerschicht mit einem entsprechenden Farbstoff ist. Beim Ablösen und Trennen der Folie 22 von dem Trägermaterial 21 wird dann die gefärbte Kunstharzschicht von dem Trägermaterial auf die empfangende Folie 22 übertragen. Im Anschluß daran kann dann die Belichtung dieser so erhaltenen Farbprüffolie erfolgen.

Als Trägermaterial 21 kommt auch eine Leiterplatte mit aufbelichtetem Fotoresistmuster in Betracht, die Folie 22 ist dann eine Schutzfolie für das aufbelichtete Fotoresistmuster. Nach dem Belichten der Leiterplatte wird die Schutzfolie entfernt und das Fotoresistmuster in verschiedenen Bädern entwickelt. Die Schutzfolie muß entfernt werden, ohne daß es zu Beschädigungen des Fotoresistmusters kommt und/oder ohne daß Reste der Schutzfolie auf dem Fotoresistfilm verbleiben.

Wie aus Figur 1 ersichtlich ist, umgibt ein Gehäuse 30, das teilweise aufgebrochen gezeigt ist, die Spindel 12, parallel zu der Führungsstangen 27 und 28 verlaufen, entlang denen die Trennvorrichtung 10 mittels der Führung 11 verfahren wird.

Wie aus Figur 2 zu ersehen ist, ist die Folie 22 derart auf das Trägermaterial 21 auflaminiert, daß ringsum Ränder 32 des Trägermaterials 21 frei von der auflaminierten Folie 22 bleiben. Das Laminat 23 aus dem Trägermaterial 21 und der Folie 22 ist zwischen der Grundplatte 15 und der Platte 16 so angeordnet, daß die Diagonale 26 des rechteckigen oder quadratischen Laminats in Vorschubrichtung der Trennvorrichtung 10 ausgerichtet ist. Eine Folienecke 24 der Folie 22 liegt auf der Diagonale 26.

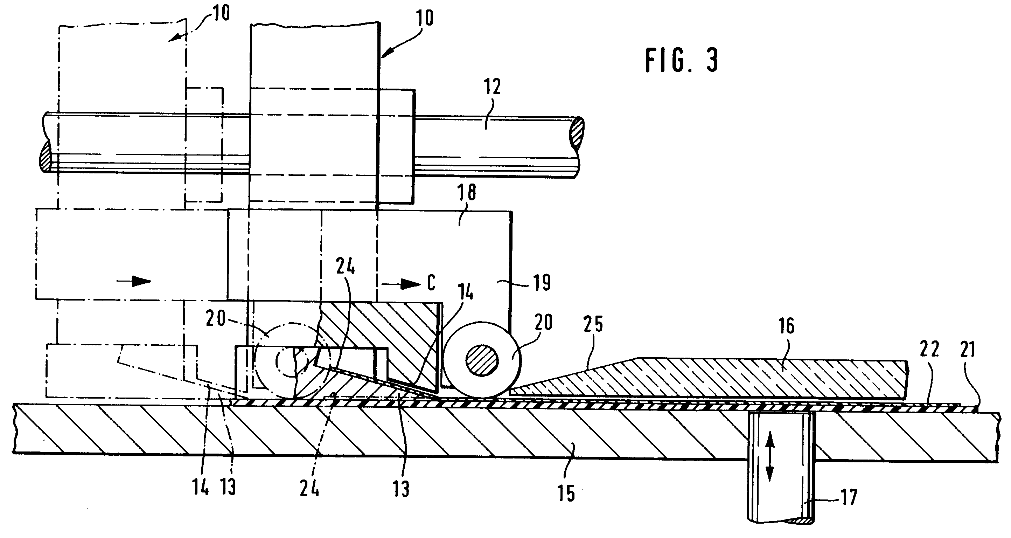

Aus Figur 3 ist zu ersehen, daß die Trennvorrichtung 10 ein keilförmiges Trennmesser 13 aufweist, über dem sich ein dazu parallel verlaufender Spalt 14 befindet, der mit der gleichen Neigung wie die obere Fläche des keilförmigen Trennmessers schräg zu der Horizontalen geneigt ist. In Figur 3 sind zwei Positionen der Trennvorrichtung 10 in Vorschubrichtung dargestellt. In der ersten, linken Position, strichpunktiert dargestellt, befindet sich die Trennvorrichtung 10 und damit das Trennmesser 13 kurz vor der Folienecke 24, eine Ablösung der Folienecke 24 von dem Trägermaterial 21 findet zu diesem Zeitpunkt noch nicht statt. Die Trennvorrichtung 10 ist an der Unterseite eines Winkelrahmens 18 befestigt, der einen horizontalen und vertikalen Schenkel aufweist. Im vertikalen Schenkel 19 ist am unteren Ende eine Rolle 20 drehbar gelagert, die während des Vorschubs zunächst über das Laminat 23 abrollt. In der zweiten, rechten Position in Figur 3 hat das keilförmige Trennmesser 13 die Folienecke 24 der Folie 22 von dem Trägermaterial 21 abgelöst und diese Folienecke 24 in den Spalt 14 eingefädelt. Die Rolle 20 befindet sich dann unmittelbar an der Vorderseite, d.h. am Beginn der Schräge 25 der Platte 16. Der Stempel 17, der die Grundplatte 15 vertikal durchdringt, drückt in dieser Position der Trennvorrichtung 10 das Laminat 23 gegen die Unterseite der Platte 16 und hält es fest, so daß die losgelöste Folienecke 24 ohne Schwierigkeiten in den Spalt 14 eingefädelt werden kann. Der Stempel 17 ist pneumatisch oder hydraulisch anhebbar und absenkbar. Die hierfür erforderliche pneumatische oder hydraulische Vorrichtung ist im Stand der Technik bekannt und daher in der Zeichnung nicht dargestellt.

Das Trennmesser 13 bildet gewissermaßen die Unterseite des Spalts 14, der einen Winkel im Bereich von 5 bis 25°, insbesondere von 10 bis 20° in Vorschubrichtung der Trennvorrichtung 10 mit der Horizontalen einschließt. In einem speziellen Ausführungsbeispiel beträgt der Winkel des Spalts mit der Horizontalen 15°. Die Spaltlänge ist gleich oder größer als 20 mm. Insbesondere eine Spaltlänge von 30 mm hat sich bei Versuchen als günstig erwiesen. Die Folienecke 24 wird im allgemeinen bis zu 20 mm in den Spalt eingefädelt. Während des weiteren Vorschubs der Trennvorrichtung wird die eingefädelte Folienecke 24 selbstklemmend von dem Trennmesser 13 im Spalt festgehalten.

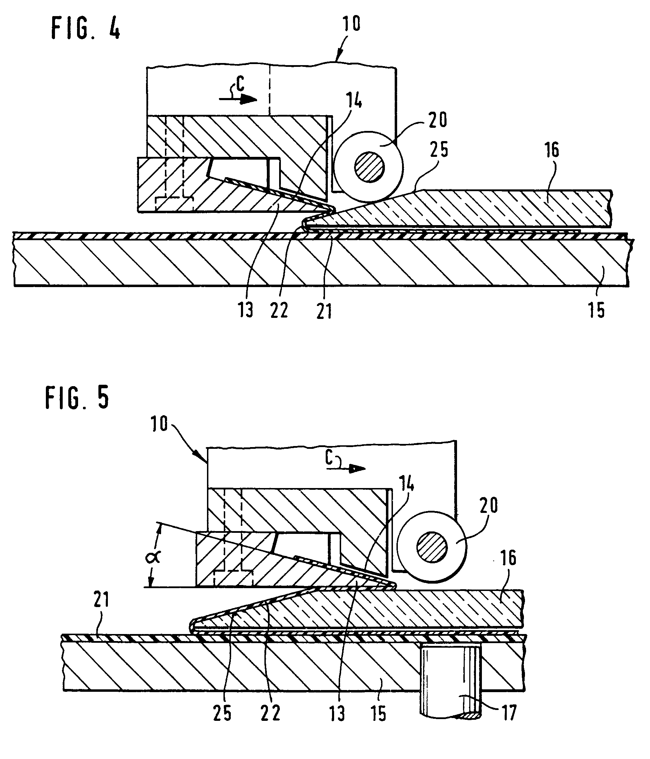

Figur 4 zeigt eine Position der Trennvorrichtung 10, in der sich die Rolle 20 auf der Schräge 25 der Platte 16 hochbewegt und dadurch die Trennvorrichtung 10 von dem Laminat 23 auf der Grundplatte 15 abhebt. In diesem Zusammenhang ist darauf hinzuweisen, daß die Trennvorrichtung 10 in Vertikalrichtung gegenüber der Grundplatte 15 verschiebbar ist. Die Folie 22 ist in dieser Stellung um die Vorderkante beziehungsweise um die Anfangskante der Schräge 25 geknickt herumgeführt und mit einem weiteren, dazu entgegengesetzten Knick in den Spalt 14 der Trennvorrichtung 10 eingefädelt. In dieser Position wird selbstverständlich das Laminat 23 durch den Stempel 17 nicht mehr festgehalten, der nach unten abgesenkt ist.

In Figur 5 ist eine Position der Trennvorrichtung 10 gezeigt, in der diese sich über die Oberfläche der Platte 16 entlang bewegt. Der Winkel α des keilförmigen Trennmessers 13 liegt in dem zuvor angegebenen Winkelbereich für den Spalt 14, beziehungswiese hat die gleiche Größe von 15° wie das voranstehend erwähnte bevorzugte Ausführungsbeispiel für den Spalt 14. In dieser Position ist die Rolle 20 von der Oberseite der Platte 16 abgehoben, was dadurch zustande kommt, daß der tiefste Punkt der Rolle 20, wie beispielsweise aus Figur 5 zu ersehen ist, über der Ebene der Horizontalfläche des keilförmigen Trennmessers 13 liegt. Diese Maßnahme ist erforderlich, damit das Trennmesser 13 problemlos die Folienecke 24 von dem Trägermaterial 21 loslösen kann. Aus Figur 5 ist auch ersichtlich, daß der Stempel 17 abgesenkt ist und keinen Kontakt mit der Unterseite des Laminats beziehungsweise des Trägermaterials hat. Die Vorschubrichtung der Trennvorrichtung 10 ist in den Figuren 3 bis 5 durch den Pfeil C angedeutet.

Das Abtrennen und Abziehen der Folie von dem Trägermaterial läuft wie folgt ab:
Das Laminat 23, bestehend aus der Folie 22 und dem Trägermaterial 21, wird diagonal zwischen der Grundplatte 15 und der mit geringem Abstand darüberliegenden Platte 16, die an der Einlaufseite die Schräge 25 aufweist, eingeschoben. Beim Start der Vorrichtung wird das Laminat 23 durch den Stempel 17 an der Unterseite festgehalten. Die obere, abzuziehende Folie 22 liegt diagonal gemessen ungefähr 2 cm hinter der Vorderkante des Trägermaterials 21, d.h. mit anderen Worten der von der Folie 22 freigelassene Rand 32 des Trägermaterials 21 beträgt 2 cm.

Auf dem Trägermaterial 21 schiebt sich das leicht angedrückte Trennmesser 13, über die Spindel 12 von dem Motor angetrieben, in Richtung Vorderkante beziehungsweise Folienecke 24 der Folie 22 vor und löst die Folienecke 24 von dem Trägermaterial 21 ab. Die Folienecke 24 der Folie 22 schiebt sich ungefähr 20 mm in den über dem Trennmesser 13 gelegenen Spalt 14. Der von der Unterseite das Laminat 23 fixierende Stempel 17 wird in seine Ausgangslage zurückgeführt und gibt das Laminat frei. Anschließend läuft das Trennmesser 13 geführt von der Rolle 20, über die an der Vorderseite der Platte 16 befindliche Schräge 25 nach oben. Dadurch wird die in dem Spalt 14 über dem Trennmesser 13 befindliche Folie 22 in einem Winkel von 5 bis 20°, insbesondere von 15° umgeknickt und es entsteht ein selbstklemmender Halten zwischen dem Trennmesser 13 und der Folie 22 im Spalt 14.

Durch den weiteren Vorschub des Trennmessers 13 wird der Trennvorgang fortgesetzt und die beiden übereinanderlaminierten Teile lösen sich voneinander und werden in entgegengesetzte Richtungen voneinander getrennt.

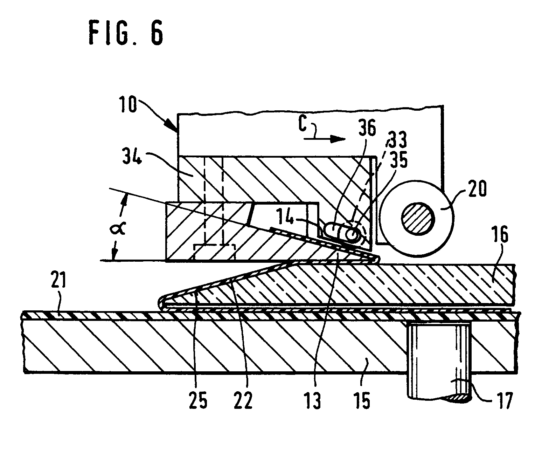

In Fig. 6 ist eine Druckrolle 33 gezeigt, die mit ihren Achsenenden 35 in zueinander parallelen Langlöchern 36 gelagert ist, die Oberseite des keilförmigen Trennmessers 13 berührt und während der Hin- und Herbewegung der Trennvorrichtung 10 entlang der Oberseite des Trennmessers auf und ab rollt. Die Langlöcher 36 verlaufen im Trennmesserkopf 34 geneigt zu dem schrägen Spalt 14. Die Druckrolle 33 übt auf die in den Spalt 14 eingefädelte Folienecke einen Klemmdruck aus, der die Selbstklemmung unterstützt für den Fall, daß es sich um großformatige und entsprechend schwere Laminate oder um dünne Trägermaterialien handelt, die wegen ihrer geringen Dicke den schrägen Spalt nicht voll ausfüllen und daher nur eine schwache Selbstklemmung erfahren.

## Patentansprüche

1. Vorrichtung zum Trennen und Abziehen einer auf einem Trägermaterial (21) auflaminierten Folie (22), mit einer horizontalen Grundplatte (15) und einer teilweise darüber im Abstand angeordneten, eine Abzugskante aufweisenden Platte (16), wobei die Grundplatte (15) und die darüber angeordnete Platte (16) einen ersten Spalt bilden, dadurch gekennzeichnet, daß eine Trennvorrichtung (10) entlang einer Spindel (12) mit Hilfe eines Motors (11) über das auf der Grundplatte (15) aufliegende Laminat (23) aus Folie (22) und Trägermaterial (21), bis über die Platte (16) hin und her verfahrbar ist, wobei die Trennvorrichtung (10) gegenüber der Grundplatte (15) in Vertikalrichtung verschiebbar ist, daß die Trennvorrichtung (10) ein keilförmiges Trennmesser (13) und ein darüberliegendes, mit der schräg zu der horizontalen geneigten Oberseite des Trennmessers (13) einen parallelen zweiten Spalt (14) bildendes Element (34) aufweist, wobei mittels einer Druckrolle (33), die in dem als Trennmesserkopf ausgebildeten Element (34) oberhalb des zweiten Spaltes (14) angordnet und auf der schrägen Oberseite des Trennmessers (13) hin und her beweglich ist, eine in den zweiten Spalt (14) eingefädelte Folienecke (24) zusätzlich festklemmbar ist, und daß das Laminat (23) während des Einfädelns einer losgelösten Folienecke (24) mittels eines hin und her bewegbaren Stempels (17), der die Grundplatte (15) vertikal durchsetzt, im ersten Spalt festklemmbar ist.

2. Vorrichtung nach Anspruch 1, dadurch gekennzeichnet, daß die Trennvorrichtung (10) an der Unterseite eines Winkelrahmens (18) befestigt ist, in dessen vertikalem Schenkel (19) am unteren Ende eine Rolle (20) drehbar gelagert ist.

3. Vorrichtung nach Anspruch 1, dadurch gekennzeichnet, daß das Trennmesser (13) die Unterseite des Spalts (14) bildet, der einen Winkel im Bereich von 5 bis 25°, insbesondere von 10 bis 20° in Vorschubrichtung der Trennvorrichtung mit der Horizontalen einschließt.

4. Vorrichtung nach Anspruch 1, dadurch gekennzeichnet, daß die Spaltlänge größer/gleich 20 mm ist.

5. Vorrichtung nach Anspruch 4, dadurch gekennzeichnet, daß die Spaltlänge 30 mm beträgt.

6. Vorrichtung nach Anspruch 1, dadurch gekennzeichnet, daß die Achsenenden (35) der Druckrolle (33) in zueinander parallelen Langlöchern (36) des Trennmesserkopfes (34) gelagert sind, die geneigt zu dem schrägen Spalt (14) verlaufen.

7. Vorrichtung nach den Ansprüchen 1 und 2, dadurch gekennzeichnet, daß die der Trennvorrichtung (10) zugewandte Vorderseite der Platte (16) eine Schräge (25) aufweist, über die die Trennvorrichtung (10) mit Hilfe der Rolle (20) nach oben auf die Oberseite der Platte (16) läuft.

8. Vorrichtung nach Anspruch 1, dadurch gekennzeichnet, daß die Platte (16) aus einem transparenten Material wie Glas oder Kunststoff besteht.

9. Vorrichtung nach Anspruch 1, dadurch gekennzeichnet, daß der Stempel (17) pneumatisch oder hydraulisch anhebbar und absenkbar ist.

10. Vorrichtung nach Anspruch 1, dadurch gekennzeichnet, daß die auf dem Trägermaterial (21) auflaminierte Folie (22) eine Farbfolie ist und daß das Laminat (23) zwischen der Grundplatte (15) und der Platte (16) so angeordnet ist, daß die Diagonale (26) des rechteckigen oder quadratischen Laminats (23) in Vorschubrichtung der Trennvorrichtung (10) ausgerichtet ist.

11. Vorrichtung nach Anspruch 1, dadurch gekennzeichnet, daß das Trägermaterial (21) eine Folie ist.

12. Vorrichtung nach Anspruch 1, dadurch gekennzeichnet, daß das Trägermaterial (21) eine Leiterplatte mit aufbelichtetem Fotoresistmuster und die Folie (22) eine Schutzfolie ist.

13. Verfahren zum Trennen und Abziehen einer auf einem Trägermaterial (21) auflaminierten Folie (22), wobei das Laminat (23) aus Folie und Trägermaterial auf einer horizontalen Grundplatte (15) aufgelegt und mit seiner Diagonalen (26) in einer parallel zur Grundplatte verlaufenden Vorschubrichtung einer Trennvorrichtung (10) ausgerichtet wird, dadurch gekennzeichnet, daß, getrennt durch einen ersten Spalt, eine Platte (16) oberhalb der Grundplatte (15) so angeordnet ist, daß zumindest eine Folienecke (24) des im ersten Spalt frei beweglichen Laminats (23) nicht durch die Platte (16) abgedeckt wird, daß das Laminat im ersten Spalt festgeklemmt wird und die Folienecke infolge einer Vorschubbewegung der Trennvorrichtung (10) mit Hilfe eines keilförmigen Trenmmessers (13) der Trennvorrichtung von dem Trägermaterial (21) losgelöst und in einen schräg zur Horizontalen verlaufenden, oberhalb des Trennmessers liegenden zweiten Spalt (14) eingefädelt wird, daß während einer weiteren Vorschubbewegung das festgeklemmte Laminat freigegeben und die Folienecke selbstklemmend im zweiten Spalt festgehalten wird und auf die Folienecke ein zusätzlicher Klemmdruck ausgeübt wird, der die Selbstklemmung der in den zweiten Spalt eingefädelten Folienecke unterstützt, wobei durch die weitere Vorschubbewegung und ein gleichzeitiges vertikales Abheben von der Grundplatte der über eine Schräge (25) auf die Oberseite der Platte (16) auflaufenden Trennvorrichtung die Folie (22) vollständig von dem Trägermaterial abgezogen wird.

14. Verfahren nach Anspruch 13, dadurch gekennzeichnet, daß vor dem Loslösen der Folienecke die Unterseite des Laminats in einer von der Folienecke entfernten Stelle angehoben und das Laminat gegen die Unterseite der Platte angedrückt und dadurch festgehalten wird.

15. Verfahren nach den Ansprüchen 13 und 14, dadurch gekennzeichnet, daß das Laminat aus Folie und Trägermaterial freigegeben wird, sobald die losgelöste Folienecke in den Spalt der Trennvorrichtung eingefädelt und festgehalten wird.

## Claims

1. An apparatus for separating and drawing off a film (22) laminated on a carrier material (21), having a horizontal base plate (15) and a plate (16) which is arranged partly thereabove at a distance and has a draw-off edge, the base plate (15) and the plate (16) arranged thereabove forming a first gap, wherein a separating apparatus (10) is able to travel back and forth along a spindle (12) with the aid of a motor (11) over the laminate (23), comprising film (22) and carrier material (21), resting on the base plate (15), up to a point over the plate (16), the separating apparatus (10) being displaceable in the vertical direction with respect to the base plate (15), wherein the separating apparatus (10) has a wedge-shaped separating knife (13) and an element (34) which lies thereabove and together with the upper side of the separating knife (13), which upper side is inclined obliquely to the horizontal, forms a parallel second gap (14), it being possible for a film corner (24), which is threaded into the second gap (14), to be additionally firmly clamped by means of a pressure roller (33) which is arranged in the element (34), formed as a separating knife head, above the second gap (14) and can be moved back and forth on the sloping upper side of the separating knife (13) and wherein the laminate (23) can be firmly clamped in the first gap by means of a stay (17), which can be moved back and forth and passed vertically through the base plate (15), while a detached film corner (24) is threaded in.

2. The apparatus as claimed in claim 1, wherein the separating apparatus (10) is fastened on the underside of an angled frame (18), in the vertical leg (19) of which a roller (20) is rotatably mounted at the lower end.

3. The apparatus as claimed in claim 1, wherein the separating knife (13) forms the underside of the gap (14), which includes an angle with the horizontal in the range from 5 to 25°, in particular from 10 to 20°, in the advancing direction of the separating apparatus.

4. The apparatus as claimed in claim 1, wherein the gap length is greater than/equal to 20 mm.

5. The apparatus as claimed in claim 4, wherein the gap length is 30 mm.

6. The apparatus as claimed in claim 1, wherein the axle journals (35) of the pressure roller (33) are mounted in mutually parallel oblong holes (36) of the separating knife head (34), which run at an inclination with respect to the oblique gap (14).

7. The apparatus as claimed in claim 1 or 2, wherein the front side of the plate (16) facing the separating apparatus (10) has a bevel (25), over which the separating apparatus (10) runs upward on the upper side of the plate (16) with the aid of the roller (20).

8. The apparatus as claimed in claim 1, wherein the plate (16) consists of a transparent material such as glass or plastic.

9. The apparatus as claimed in claim 1, wherein the stay (17) can be raised and lowered pneumatically or hydraulically.

10. The apparatus as claimed in claim 1, wherein the film (22) laminated on the carrier material (21) is a color film and wherein the laminate (23) is arranged between the base plate (15) and the plate (16) in such a way that the diagonal (26) of the rectangular or square laminate (23) is aligned in the advancing direction of the separating apparatus (10).

11. The apparatus as claimed in claim 1, wherein the carrier material (21) is a film.

12. The apparatus as claimed in claim 1, wherein the carrier material (21) is a circuit board with a photoresist pattern exposed on it and the film (22) is a protective film.

13. A process for separating and drawing off a film (22) laminated on a carrier material (21), the laminate (23), comprising film and carrier material, being placed on a horizontal base plate (15) and being aligned with its diagonal (26) in an advancing direction of a separating apparatus (10), which advancing direction runs parallel to the base plate, wherein, separated by a first gap, a plate (16) is arranged above the base plate (15) such that at least one film corner (24) of the laminate (23) which is freely movable in the first gap is not covered by the plate (16), wherein the laminate is firmly clamped in the first gap, and, as a result of an advancing movement of the separating apparatus (10), the film corner is detached from the carrier material (21) with the aid of a wedge-shaped separating knife (13) of the separating apparatus and is threaded into a second gap (14) which runs obliquely to the horizontal and lies above the separating knife, wherein the firmly clamped laminate is released during a further advancing movement and the film corner is held firm in the second gap in a self-clamping manner, and an additional clamping pressure is exerted on the film corner, assisting the self-clamping of the film corner threaded into the second gap, the film (22) being completely drawn off the carrier material by the further advancing movement and a simultaneous vertical lifting of the separating apparatus off the base plate, the separating apparatus running over a bevel (25) onto the upper side of the plate (16).

14. The process as claimed in claim 13, wherein, before detaching the film corner, the underside of the laminate is raised in a position remote from the film corner and the laminate is pressed against the underside of the plate and is thereby held firm.

15. The process as claimed in claims 13 and 14, wherein the laminate, comprising film and carrier material, is released as soon as the detached film corner is threaded into the gap of the separating apparatus and is held firm.

## Revendications

1. Dispositif pour séparer et retirer une feuille (22) plaquée sur un matériau de support (21), comportant une plaque de base horizontale (15) et une plaque (16) disposée partiellement au-dessus et à distance de la plaque de base et possédant un bord de retrait, la plaque de base (15) et la plaque (16) disposée au-dessus d'elle définissant une première fente, caractérisé en ce qu'un dispositif de séparation (10) peut être déplacé en va-et-vient le long d'une broche (12) à l'aide d'un moteur (11), au-dessus du stratifié (23) déposé sur la plaque de base (15) et formé par la feuille (22) et le matériau de support (21), jusqu'au-dessus de la plaque (16), le dispositif de séparation (10) étant déplaçable dans une direction verticale par rapport à la plaque de base (15), que le dispositif de séparation (10) possède un couteau de séparation en forme de coin (13) et un élément (34) situé au-dessus de ce couteau et formant avec la face supérieure, disposée obliquement par rapport à l'horizontale, du couteau de séparation (13), une seconde fente parallèle (14), un coin (24) de la feuille, qui est enfilé dans la seconde fente (14), pouvant être en outre bloqué fermement par serrage à l'aide d'un galet de pression (33), qui est disposé dans l'élément (34) agencé en forme de tête de couteau de séparation, au-dessus de la seconde fente (14) et est déplaçable en va-et-vient sur la face supérieure oblique du couteau de séparation (13), et que le stratifié (23) peut être bloqué par serrage dans la première fente, pendant l'enfilage d'un coin détaché (24) de la feuille, au moyen d'un poinçon (17) déplaçable en va-et-vient et qui traverse verticalement la plaque de base (15).

2. Dispositif selon la revendication 1, caractérisé en ce que le dispositif de séparation (10) est fixé à la face inférieure d'un cadre en forme de cornière (18), à l'extrémité inférieure de la branche verticale (19) duquel est monté, de manière à pouvoir tourner, un rouleau (20).

3. Dispositif selon la revendication 1, caractérisé en ce que le couteau de séparation (13) forme la face inférieure de la fente (14), qui fait, avec l'horizontale, un angle situé dans la gamme de 5 à 25°, et notamment 10 à 20° dans la direction d'avance du dispositif de séparation.

4. Dispositif selon la revendication 1, caractérisé par le fait que la longueur de la fente est supérieure/égale à 20 mm.

5. Dispositif selon la revendication 4, caractérisé en ce que la longueur de la fente est égale à 30 mm.

6. Dispositif selon la revendication 1, caractérisé en ce que les extrémités (35) de l'axe du galet de pression (33) sont tourillonnées dans des trous allongés (36) de la tête (34) du couteau de séparation, qui sont parallèles entre eux et inclinés par rapport à la fente oblique (14).

7. Dispositif selon les revendications 1 et 2, caractérisé en ce que la face avant de la plaque (16), qui est tournée vers le dispositif de séparation (10), possède un biseau (25), sur lequel le dispositif de séparation (10) circule, au moyen du rouleau (20), en remontant sur la face supérieure de la plaque (16).

8. Dispositif selon la revendication 1, caractérisé en ce que la plaque (16) est réalisée en un matériau transparent tel que du verre ou une matière plastique.

9. Dispositif selon la revendication 1, caractérisé en ce que le poinçon (17) peut être soulevé et abaissé pneumatiquement ou hydrauliquement.

10. Dispositif selon la revendication 1, caractérisé en ce que la feuille (22) plaquée sur le matériau de support (21) est une feuille colorée et que le stratifié (23) est disposé entre la plaque de base (15) et la plaque (16) de telle sorte que la diagonale (26) du stratifié rectangulaire ou carré (23) est dirigée dans la direction d'avance du dispositif de séparation (10).

11. Dispositif selon la revendication 1, caractérisé en ce que le matériau de support (21) est une feuille.

12. Dispositif selon la revendication 1, caractérisé en ce que le matériau de support (21) est une plaquette à circuits imprimés portant un modèle en résine photosensible exposé, et la feuille (22) est une feuille de protection.

13. Procédé pour séparer et retirer une feuille (22) plaquée sur un matériau de support (21), selon lequel on applique le stratifié (23) formé de la feuille et du matériau de support sur une plaque de base horizontale (15) et on l'oriente de telle sorte que sa diagonale (26) est située dans une direction d'avance, qui s'étend parallèlement à la plaque de base, d'un dispositif de séparation (10), caractérisé en ce qu'une plaque (16) est disposée au-dessus de la plaque de base (15) en en étant séparée par une première fente, qu'au moins un coin (24) de la feuille du stratifié (23) librement déplaçable dans la première fente n'est pas recouvert par la plaque (16), qu'on bloque par serrage le stratifié dans la première fente et qu'en raison d'un déplacement d'avance du dispositif de séparation (10), le coin de la feuille est détaché du matériau de support (21) à l'aide d'un couteau de séparation en forme de coin (13) du dispositif de séparation et est enfilé dans une seconde fente (14) qui s'étend obliquement par rapport à l'horizontale et est située au-dessus du couteau de séparation et que pendant un autre déplacement d'avance, le stratifié bloqué par serrage est libéré et le coin de la feuille est maintenu fermement d'une manière auto-bloquante dans la seconde fente, et que sur le coin de la feuille est appliquée une pression de serrage supplémentaire, qui assiste le blocage par le serrage automatique du coin de la feuille, enfilé dans la seconde fente, auquel cas, sous l'effet de la poursuite du déplacement d'avance et d'un soulèvement vertical simultané de la plaque de base du dispositif de séparation qui remonte par-dessus un biseau (25) sur la surface supérieure de la plaque (16), la feuille (22) est complètement retirée du matériau de support.

14. Procédé selon la revendication 13, caractérisé en ce qu'avant le détachement du coin de la feuille, la face inférieure du stratifié est soulevée en un emplacement éloigné du coin de la feuille, et le stratifié est repoussé contre la face inférieure de la plaque et est maintenu fermement par cette dernière.

15. Procédé selon les revendications 13 ou 14, caractérisé en ce que le stratifié formé par la feuille et le matériau de support est libéré dès que le coin détaché de la feuille est enfilé et retenu fermement dans la fente du dispositif de séparation.
